# EUROPÄISCHE PATENTSCHRIFT

(11) **EP 1 112 612 B1**
(45) Veröffentlichungstag und Bekanntmachung des Hinweises auf die Patenterteilung: **27.11.2002**
(21) Anmeldenummer: 99953663.4
(22) Anmeldetag: 01.09.1999
(51) Int. Cl.: H01S 5/022, G02B 6/42

(54) **ANORDNUNG MIT LICHTEMITTIERENDEM LEISTUNGSHALBLEITERBAUELEMENT SOWIE VERFAHREN ZUR HERSTELLUNG DERSELBEN**
ARRAY WITH LIGHT-EMITTING POWER SEMICONDUCTOR COMPONENT AND CORRESPONDING PRODUCTION METHOD
SYSTEME COMPORTANT UN COMPOSANT SEMI-CONDUCTEUR DE PUISSANCE ELECTROLUMINESCENT ET PROCEDE PERMETTANT DE LE PRODUIRE

(30) Priorität: 09.09.1998 DE 19841204
(43) Veröffentlichungstag der Anmeldung: 04.07.2001
(73) Patentinhaber: Osram Opto Semiconductors GmbH & Co. OHG, 93049 Regensburg (DE)
(72) Erfinder: ACKLIN, Bruno, D-93047 Regensburg (DE); SPÄTH, Werner, D-83607 Holzkirchen (DE); GRÖTSCH, Stefan, D-93053 Regensburg (DE)
(74) Vertreter: Epping, Wilhelm, Dipl.-Ing.
(86) Internationale Anmeldenummer: DE9902750
(87) Internationale Veröffentlichungsnummer: WO00014837

(56) Entgegenhaltungen:
- EP-A- 0 450 560
- EP-A- 0 589 711
- US-A- 5 516 727
- US-A- 5 548 605
- PATENT ABSTRACTS OF JAPAN vol. 010, no. 069 (E-389), 18. März 1986 (1986-03-18) & JP 60 217687 A (HITACHI SEISAKUSHO KK), 31. Oktober 1985 (1985-10-31)

## Beschreibung

Die Erfindung betrifft eine Anordnung mit einem lichtemittierenden Leistungshalbleiterbauelement nach dem Oberbegriff des Anspruchs 1 sowie eine Verfahren zur Herstellung einer derartigen Anordnung gemäß Anspruch 16, vgl. z.B. US-A-5 516 727.

Es ist bereits bekannt, ein lichtemittierendes Leistungshalbleiterbauelement, insbesondere Halbleiterlaser, auf einer Kupferplatte anzubringen, und die Kupferplatte zur effizienten Ableitung der in dem Leistungshalbleiterbauelement umgesetzten Verlustwärme mit einer Wasserkühlung zu koppeln. Die Verbindung zwischen der Kupferplatte und dem Leistungshalbleiterbauelement kann dabei durch Löten oder Kleben realisiert sein.

Ferner ist es bereits bekannt, das Leistungshalbleiterbauelement einer derartigen Anordnung zum Schutz vor Umgebungseinflüssen in einem Gehäuse unterzubringen. Das Gehäuse wird üblicherweise durch die Kupferplatte selbst und eine auf der Kupferplatte aufsitzende, das Leistungshalbleiterbauelement umgebende Metallkappe gebildet.

Die bei dieser bekannten Lösung in der Praxis auftretenden Schwierigkeiten betreffen hauptsächlich die thermische und/oder mechanische Ankopplung des Leistungshalbleiterbauelements an die Wärmesenke (Kupferplatte) und die Auskopplung der optischen Nutzleistung aus dem Gehäuse. Hinsichtlich des ersten Aspekts ist problematisch, daß zwischen den thermischen Ausdehnungskoeffizienten der üblicherweise verwendeten Halbleitermaterialien (z.B. GaAs) und dem thermischen Ausdehnungskoeffizienten von Kupfer eine große Differenz (etwa Faktor 3) vorhanden ist. Dadurch besteht die Gefahr, daß das Verbindungsgefüge (beispielsweise Lötung oder Klebung) zwischen dem Leistungshalbleiterbauelement und der Kupferplatte mit der Zeit mechanisch beeinträchtigt wird, wodurch der Wärmeübergangswiderstand zunimmt und im Extremfall sogar ein Abplatzen des Leistungshalbleiterbauelements auftreten kann. Hinsichtlich des zweiten Aspekts ist zur Auskopplung der optischen Laserleistung aus dem Gehäuse ein gegebenenfalls mit einer Optik versehenes Austrittsfenster oder - bei Verwendung eines Lichtwellenleiters - eine Wellenleiterdurchführung durch die Metallkappe erforderlich. Hier treten in der Praxis nicht selten Justageschwierigkeiten auf.

Darüber hinaus ist nachteilig, daß die erwähnte Anordnung aufgrund des Metallkappengehäuses mit Lichtaustrittsfenster oder Wellenleiterdurchführung in der Herstellung relativ teuer ist und einen aufwendigen Montageablauf erforderlich macht.

In der Druckschrift DE 197 06 279 A1 ist eine Laservorrichtung beschrieben, die einen Leistungshalbleiterlaser umfaßt, der auf einem metallischen Grundträger befestigt ist. Auf dem metallischen Grundträger ist ein Gehäusedeckel angebracht, der einen transparenten Lichtaustrittsbereich umfaßt.

In der europäischen Patentanmeldung EP 0 869 590 A1 ist eine Vertikalresonator-Laserdiode beschrieben, die in einem Gehäuse untergebracht ist, das boden-, wand- und deckenseitig aus Kunststoff besteht. In der Gehäusedecke ist ein Leistungsüberwachungssystem integriert.

In der Druckschrift US 5,327,443 ist ein auf einer metallischen Wärmesenke montierter Leistungshalbleiterlaser beschrieben, der von einem kappenartigen Gehäusedeckel umgeben ist. Der Gehäusedeckel kann als einstückiges KunststoffSpritzteil realisiert sein und umfaßt ein transparentes Lichtaustrittsfenster.

In der europäischen Patentanmeldung EP 0 592 746 A1 ist eine Laseranordnung beschrieben, bei der eine Laserdiode und ein Lichtwellenleiter gemeinsam mit einem Gießharz vergossen werden. Die Laserdiode ist von der Gießharzumhüllung mit Ausnahme ihrer Lichtaustrittsfläche formbündig umhüllt.

Der Erfindung liegt die Aufgabe zugrunde, eine einfach aufgebaute und kostengünstig herstellbare Anordnung mit einem eingehäusten, vor Umwelteinflüssen geschützten lichtemittierenden Leistungshalbleiterbauelement zu schaffen. Ferner zielt die Erfindung darauf ab, ein Verfahren zur Herstellung einer derartigen Anordnung anzugeben, das fertigungstechnisch einfach und kostengünstig durchführbar ist.

Die der Erfindung zugrundeliegende Aufgabe wird durch die Merkmale der Ansprüche 1 und 16 gelöst.

Gemäß der Erfindung ist das Leistungshalbleiterbauelement in einem Kunststoffschutzkörper untergebracht, wobei die Ableitung der Verlustwärme hauptsächlich über die metallische Trägerstruktur erfolgt. Der Kunststoffschutzkörper wird dabei durch einfaches Anspritzen einer aushärtenden Kunststoffmasse an die vorgefertigte Trägerstruktur geschaffen, so daß diese bis auf den Lichtaustrittsbereich im wesentlichen formbündig umhüllt wird. Der ausgesparte Lichtaustrittsbereich kann dabei beispielsweise durch ein vor dem Anspritzschritt geeignet positioniertes und später zu entfernendes Opferteil oder durch einen Lichtwellenleiter realisiert sein. Die im Stand der Technik zur Einhäusung verwendete Metallkappe entfällt. Der wesentliche Vorteil des erfindungsgemäßen Aufbaus besteht darin, daß er in einfacher und kostengünstiger Weise realisierbar ist und dennoch den praktischen Erfordernissen hinsichtlich der Abführung von thermischer Verlustleistung und der Auskopplung der optischen Nutzleistung in vollem Maße genügt.

Vorzugsweise besteht der Kunststoffschutzkörper aus einem im wesentlichen opaken Kunststoffmaterial. Es hat sich gezeigt, daß.optisch durchsichtige Kunststoffmaterialien zumeist eine deutlich schlechtere Anpassung an die thermische Ausdehnung des Leistungshalbleiterbauelements im Betrieb aufweisen. Durch Einbringen von dispergierten Füllstoffpartikeln, insbesondere Glaspartikeln in den Kunststoffschutzkörper kann die thermische Anpassung zwischen Leistungshalbleiterbauelement und Kunststoffschutzkörper günstig beeinflußt und ggf. noch weiter verbessert werden.

Der Kunststoffschutzkörper kann zweckmäßigerweise sowohl aus einem Thermoplast als auch aus einem Duroplast bestehen, wobei sich in der Praxis aus einem Thermoplast bestehende Kunststoffschutzkörper als besonders geeignet erwiesen haben. Es können aber auch andere Kunststoffe, beispielsweise Gießharze oder Globetopmassen zum Aufbau des Kunststoffschutzkörpers eingesetzt werden.

Vorzugsweise ist die Trägerstruktur ein aus einem Metallblech, insbesondere einem Leadframe gefertigtes Vereinzelungsteil, insbesondere Stanzteil. Leadframes werden in großem Umfang als Träger für herkömmliche elektronische Bauelemente eingesetzt und können mit vorhandenen Fertigungstechniken kostengünstig in großen Stückzahlen hergestellt werden.

Nach einer bevorzugten Ausführungsform der Erfindung steht die Trägerstruktur mit einem Kühlmedium, insbesondere Wasser in thermischem Kontakt und wird von diesem zumindest teilflächig um- oder angeströmt. Auf diese Weise kann auch mit verhältnismäßig dünnwandigen Trägerstrukturen eine ausreichende Kühlwirkung erreicht werden. Es ist jedoch auch möglich, ohne ein Kühlmedium zu arbeiten. In diesem Fall erfolgt die Entwärmung des Leistungshalbleiterbauelements über die Festkörper-Wärmeableitung entlang der bzw. durch die Trägerstruktur. Die Trägerstruktur muß dann in geeigneter Weise über eine gut wärme(ab)leitende Verbindung mechanisch gehaltert sein.

Eine Ausführungsvariante kennzeichnet sich dadurch, daß die Trägerstruktur mit einem Mikrokanäle und/oder Mikrolamellen aufweisenden Wärmeaustauschkörper versehen ist. Derartige Mikrokühler sind als solche bereits bekannt und beispielsweise in der DE 43 15 580 A1 beschrieben. Die Mikrokanäle und/oder Lamellen können beispielsweise durch Laserbearbeitung, Fräsen, Stanzen oder Galvanotechnik realisiert sein und sind zweckmäßigerweise in unmittelbarer Nähe des Leistungshalbleiterbauelements an der Unterseite der Trägerstruktur angebracht. Dadurch wird eine effiziente thermische Ankopplung des Leistungshalbleiterbauelements an den Wärmeaustauschkörper erreicht.

Nach einer bevorzugten Ausführungsform ist ein optisch an das lichtemittierende Leistungshalbleiterbauelement angekoppelter Lichtwellenleiter vorgesehen, der das emittierte Licht aus dem Kunststoffschutzkörper herausführt.

Der Lichtwellenleiter kann je nach dem konkreten Bedarfs- bzw. Einsatzfall gezielt vorgebbare Lichtwellen-Führungseigenschaften aufweisen. Beispielsweise kann der Lichtwellenleiter mit einer an seinen Längsseiten vorgesehenen Beschichtung, insbesondere SiO₂-Beschichtung versehen sein.

Darüber hinaus kann zum Zwecke einer geeigneten Lichtwellenführung auch eine interne, eine Mehrzahl von Einzellichtwellenleitern realisierende Strukturierung des Lichtwellenleiters von Vorteil sein. Eine derartige Strukturierung kann in an sich bekannter Weise beispielsweise durch ein lonenaustauschverfahren oder ein planares Verfahren (laterale Strukturierung einer lichtwellenleitenden Kernschicht zwischen zwei Mantelschichten im Lichtwellenleiter) erreicht werden. Gemäß der Erfindung kann dabei die optische Eintritts- und die optische Austrittsquerschnittsfläche bezüglich eines Einzellichtwellenleiters unterschiedlich groß gewählt werden und es ist auch möglich, bezüglich mehrerer Einzellichtwellenleiter die geometrische Anordnung der optischen Eintrittsquerschnittsflächen unterschiedlich zu der geometrischen Anordnung der Austrittsquerschnittsflächen zu gestalten. Durch diese konstruktiven Maßnahmen läßt sich eine sehr definierte und nach Wunsch vorgebbare Lichtintensitätsverteilung am Austrittsbereich des Lichtwellenleiters schaffen.

Bei Vorsehen eines derartigen Lichtwellenleiters kennzeichnet sich ein herstellungstechnisch günstiger Verfahrensablauf dadurch, daß der Lichtwellenleiter in dem bereits erwähnten Anspritzschritt vollständig in den Kunststoffschutzkörper eingehüllt wird und daß in einem nachfolgenden Schritt eine Lichtaustrittsfläche des Lichtwellenleiters im Bereich des Außenumfangs des Konturbereichs beispielsweise durch Abbrechen eines an dem Kunststoffschutzkörper vorhandenen Kunststoffüberstands freigelegt wird. Wird anstelle des Lichtwellenleiters in alternativer Weise ein Abstandsteil (Opferteil) zur Schaffung des Lichtaustrittsbereichs verwendet, wird in diesem Fall (d.h. bei Vorhandensein eines Kunststoffüberstandes) zunächst der Kunststoffüberstand abgebrochen und danach das Abstandsteil durch Herausziehen entfernt.

Weitere bevorzugte Ausgestaltungen der Erfindung sind in den Unteransprüchen angegeben.

Die Erfindung wird nachfolgend anhand eines einzigen Ausführungsbeispiels unter Bezugnahme auf die Zeichnung beschrieben; in dieser zeigt:
- Fig. 1: eine schematische Darstellung einer erfindungsgemäßen Anordnung im Aufriß;
- Fig. 2: eine schematische Darstellung der in Fig. 1 gezeigten Anordnung in Draufsicht;
- Fig. 3: eine Einzelheit X der in Fig. 1 gezeigten Anordnung;
- Fig. 4: eine Einzelheit Y der in Fig. 3 gezeigten Anordnung; und
- Fig. 5: eine Prinzipdarstellung zur Erläuterung des endseitigen Freilegens eines optischen Wellenleiters.

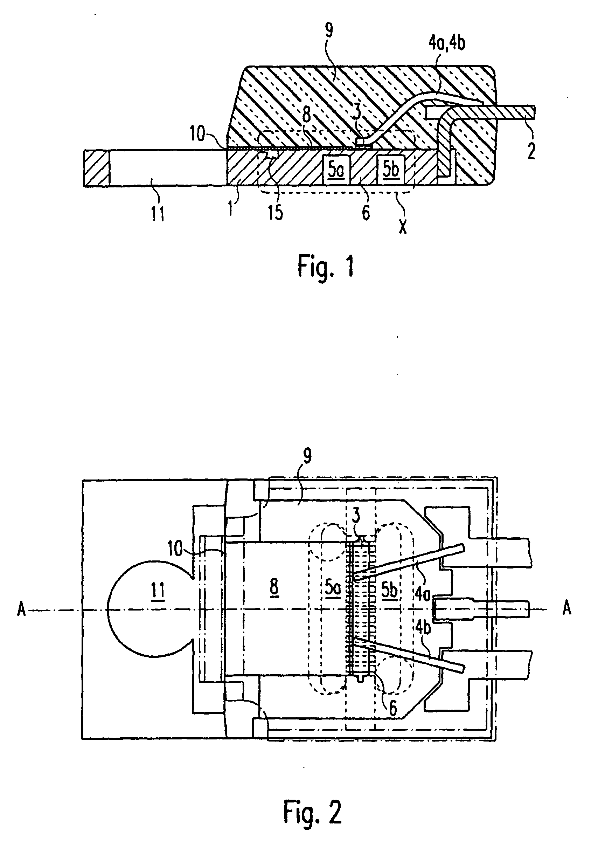

Nach den Fig. 1 und 2 weist eine erfindungsgemäße Anordnung einen aus Cu bestehenden Träger 1 auf. Bei dem hier dargestellten Träger 1 handelt es sich um ein TO 220 Leadframe, das in der Technik standardmäßig als Träger für Halbleitertransistoren verwendet wird. Der Träger 1 ist an seinem einen Ende mit einer Metallasche 2 verbunden, die den Träger 1 in Art einer elektrischen Zuleitung kontaktiert und ferner auch als mechanische Halterung des Trägers 1 dienen kann.

Auf einer Oberfläche der Trägers 1 ist ein Leistungshalbleiterlaser 3 montiert. Der Träger 1 bildet den ersten elektrischen Anschluß des Leistungshalbleiterlasers 3. Der Leistungshalbleiterlaser 3 ist in Form eines Laserbarrens ausgeführt, der sich in Querrichtung bezüglich einer in Fig. 2 dargestellten Mittellängsachse A der Anordnung erstreckt.

An seiner von dem Träger 1 abgewandten Oberseite wird der barrenförmige Leistungshalbleiterlaser 3 von zwei Bondleitungen 4a, 4b elektrisch kontaktiert. Die Bondleitungen 4a, 4b realisieren den zweiten elektrischen Anschluß des Leistungshalbleiterlasers 3.

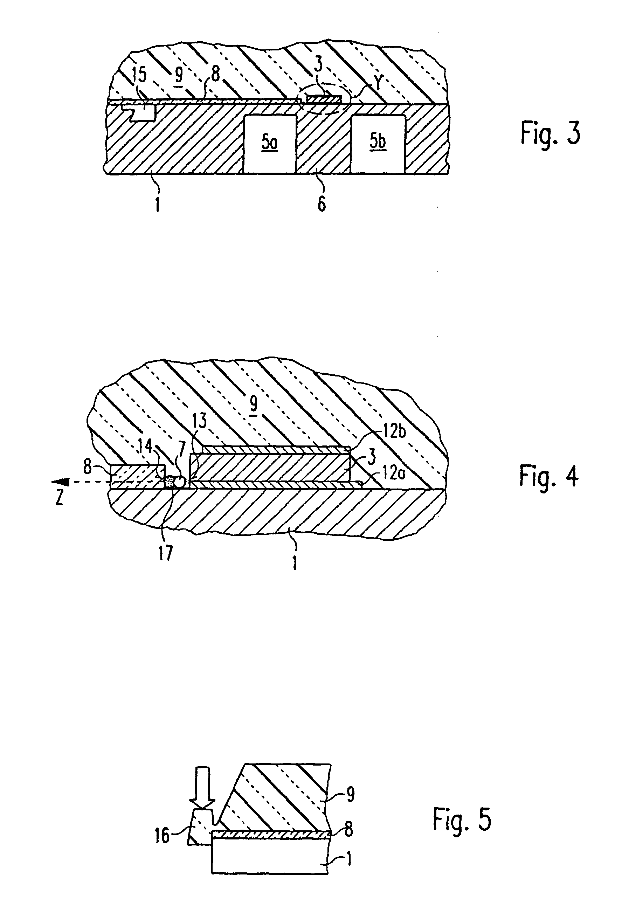

Der Träger 1 ist an seiner Unterseite mit einem integrierten Mikrokühler ausgestattet (siehe auch Fig. 3). Der Mikrokühler umfaßt einen Kühlmittelzulaufkanal 5a und einen Kühlmittelablaufkanal 5b, die sich parallel und in Projektion beidseitig des Leistungshalbleiterlasers 3 erstrecken. Die beiden Kühlmittelkanäle 5a, 5b stehen über einen als integrale Lamellenstruktur ausgebildeten Wärmeaustauschkörper miteinander in Fluidverbindung. Neben oder anstelle der Lamellenstruktur können auch andere Mikrostrukturen, z.B. Mikrokanäle, in dem Wärmeaustauschkörper realisiert sein. Aufgrund der großen Oberfläche der Lamellen 6 wird ein sehr effizienter Wärmeaustausch zwischen den Lamellen 6 und der durch die Lamellen 6 hindurchströmenden Kühlflüssigkeit, insbesondere Wasser, gewährleistet. Dadurch kann die von dem Leistungshalbleiterlaser 3 auf den Träger 1 (Wärmesenke) übertragene Verlustwärme über den Mikrokühler rasch und effizient abgeführt werden. Dabei kann die zwischen dem Leistungshalbleiterlaser 3 und dem Wärmeaustauschkörper verlaufende Bodenstruktur des Trägers 1 sehr dünnwandig sein und beispielsweise eine Stärke von weniger als 1 mm, insbesondere etwa 0,2 mm aufweisen, wodurch ein kurzer Wärmeleitungsweg mit geringem Wärmeleitungswiderstand realisiert wird.

Der Leistungshalbleiterlaser 3 ist als ein in einer Parallelebene zu der Mittellängsachse A emittierender Kantenemitter ausgeführt. Das emittierte Laserlicht wird, wie im folgenden noch näher anhand Fig. 4 beschrieben, mittels einer Zylinderlinse 7 in einen auf dem Träger 1 fixierten Lichtwellenleiter 8 eingekoppelt. Der Lichtwellenleiter 8 kann aus Glas bestehen und ist, wie in Fig. 2 erkennbar, beispielsweise als optische Platte mit rechteckiger Umfangskontur und einer Breite im Bereich von 5 bis 10 mm ausgebildet.

Gemäß der Erfindung ist bei der hier dargestellten Ausführungsform die aus Leistungshalbleiterlaser 3, Lasche 2, Bonddrähten 4a, 4b und Lichtwellenleiter 8 gebildete Anordnung von einer ein Schutzgehäuse 9 bildenden Kunststoffmasse, insbesondere einem Thermoplast umhüllt. Der Lichtwellenleiter 8 ist dabei bis zu einer Kante 10 des Schutzgehäuses 9 geführt. Er kann in der bereits beschriebenen Weise als strukturierter Lichtwellenleiter ausgebildet sein.

In dem hier gezeigten Träger 1 (d.h. einem TO 220 Leadframe) ist eine Montageöffnung 11 vorgesehen, die bei der üblichen Verwendung des TO 220 Leadframes zur Anbringung eines Transistors genutzt wird und für die vorliegende Erfindung somit nicht von Bedeutung ist.

Die Fig. 4 zeigt die in Fig. 3 eingezeichnete Einzelheit Y in vergrößerter Darstellung. Zwischen dem Leistungshalbleiterlaser 3 und dem Träger 1 einerseits und dem Leistungshalbleiterlaser 3 und den in Fig. 4 nicht dargestellten Bondleitungen 4a, 4b andererseits sind jeweils mit einer AuSn-Beschichtung verlötete Mo-Folien 12a, 12b vorgesehen. Dabei ist die untere Mo-Folie 12a beidseitig und die obere Mo-Folie 12b zumindest unterseitig, d.h. an.der dem Leistungshalbleiterlaser 3 zugewandten Seite, mit der AuSn-Lötbeschichtung versehen. Die Mo-Folien 12a, 12b dienen zur Kompensation von mechanischen Spannungen, die aufgrund der bereits angesprochenen Fehlanpassung bezüglich des thermischen Ausdehnungsverhaltens zwischen GaAs-Leistungshalbleiterlaser 3 und Cu-Träger 1 bzw. Cu-Bondleitungen 4a, 4b auftreten. Durch den beschrieben Aufbau wird eine dauerhaft mechanisch und thermisch stabile Anbindung des Leistungshalbleiterlasers 3 an den Träger sowie an die Bondleitungen 4a, 4b bewirkt. Darüber hinaus sorgt die obere Mo-Folie 12b für eine gleichmäßige Verteilung der auftretenden hohen Betriebsströme über die Oberfläche des Leistungshalbleiterlasers 3.

Die sich im Strahlengang Z hinter dem Lichtaustritt an der emittierenden Kante 13 des Leistungshalbleiterlasers 3 befindende Zylinderlinse 7 kann beispielsweise einen Durchmesser von etwa 50 µm bis 500 µm aufweisen. Sie dient dazu, das an der Kante 13 mit einer gewissen Strahldivergenz aus dem Leistungshalbleiterlaser 3 austretende Laserlicht auf eine Lichteintrittsfläche 14 des Lichtwellenleiters 8 zu konzentrieren oder zu fokussieren und ist daher sowohl von der Kante 13 als auch von der Lichteintrittsfläche 14 beabstandet.

Die Lage der Zylinderlinse 7 kann durch zwei nicht dargestellte rahmenfeste Anschläge definiert sein, die an den Stirnseiten des barrenförmigen Leistungshalbleiters 3 in Richtung der Mittellängsachse A mit einem definierten Abstand über die lichtemittierende Kante 13 des Leistungshalbleiterlasers 3 hervorstehen. Die rahmenfesten Anschläge können in nicht dargestellter Weise beispielsweise in die untere Mo-Folie 12a eingearbeitet sein.

Zur Herstellung der dargestellten Anordnung wird zunächst der Träger 1 bereitgestellt. Dabei kann es sich bei dem Träger 1 entweder um eine bereits vorgefertigte, separate Komponente (beispielsweise Stanzteil) handeln, oder es kann im Rahmen der Leadframe-Technik eine Mehrzahl von Trägern 1 als Montagefelder in einem panelartigen Metallblech oder einem kontinuierlichen Metallband (beides wird als Leadframe bezeichnet) bereitgestellt werden. In dem zweiten Fall ist vorteilhaft, daß ein Teil oder auch sämtliche der im folgenden beschriebenen Prozeßschritte zur Herstellung der erfindungsgemäßen Anordnungen im Verbund, d.h. gemeinsam auf dem Metallblech bzw. Metallband (Leadframe) durchgeführt werden können.

Es wird dann zunächst der Leistungshalbleiterlaser 3 in der bereits beschriebenen Weise auf dem Träger 1 durch Löten befestigt und mittels der Bondleitungen 4a, 4b elektrisch kontaktiert.

Nachfolgend wird die Zylinderlinse 7 im Bereich ihrer axialen Enden an die beiden erwähnten rahmenfesten Anschläge geschoben und in dieser Lage an den Anschlägen oder dem Träger 1 fixiert. Danach - oder auch bereits vor dem Einbringen der Zylinderlinse 7 - wird der Lichtwellenleiter 8 an dem Träger 1 durch Kleben oder dergleichen festgelegt. Schließlich wird der Freiraum zwischen der Lichteintrittsfläche 14 des Lichtwellenleiter 8 und der Zylinderlinse 7 mit einem kleinen Tropfen transparenten Kunststoff 17, beispielsweise Silikon verfüllt.

Im gleichen Arbeitsschritt kann auch der Freiraum zwischen der lichtemittierenden Kante 13 des Leistungshalbleiterl'asers 3 und der Zylinderlinse 7 mit dem transparenten Kunststoff 17 verfüllt werden. Es ist auch möglich, den oder die genannten Freiräume oder den gesamten Bereich zwischen dem Lichtwellenleiter 8 und dem Leistungshalbleiterlaser 3 geeignet abzudekken, so daß sich beim nachfolgenden Anspritzschritt des Kunststoffschutzgehäuses 9 dort ein Hohlraum (d.h. eine Luftkammer) ausbildet. Durch die genannten Maßnahmen wird vermieden, daß beim Anspritzschritt Kunststoffmaterial des Schutzgehäuses 9 in den Strahlengang eintritt und diesen unterbrechen oder verschatten kann.

In einem folgenden Schritt wird das Schutzgehäuse 9 angebracht. Das Anbringen des Schutzgehäuses 9 erfolgt durch direktes Anspritzen beispielsweise mittels eines opaken Thermoplastmaterials bei einem Druck von 80 bis 110 bar und einer Prozeßtemperatur von 180°C. Dabei wird auch eine in den Fig. 2 und 3 gezeigte Verankerungsausnehmung 15 am Träger 1 mit Thermoplastmaterial gefüllt. Die Aushärtung kann bei etwa 175°C durchgeführt werden und dauert etwa 2 Stunden. Es sind je nach verwendetem Kunststoff auch andere Herstellungsparameter möglich. Das Schutzgehäuse 9 ist dann über die Verankerungsausnehmung 15 fest mit dem Träger 1 verbunden. Zur Ausbildung einer unlösbaren Verbindung kann die Verankerungsausnehmung 15 mit einer Rückhalteverzahnung versehen sein.

Vorzugsweise werden in den flüssigen Thermoplast vor dem Anspritzschritt Glaspartikel eingebracht, wodurch seine thermomechanischen Eigenschaften günstig beeinflußt werden.

Nach dem Anspritzschritt wird eine Lichtaustrittsfläche des Lichtwellenleiters 8 am Umfangsbereich des Schutzgehäuses 9 freigelegt. Nach Fig. 5 ist zu diesem Zweck am Schutzgehäuse 9 ein hervorstehender Kunststoffüberstand 16 vorgesehen, der einen Endbereich des Lichtwellenleiters 8 umhüllt. Die Lichtaustrittsfläche kann durch einfaches Abrechen oder Abschneiden des Kunststoffüberstandes 16 erzeugt werden. Gegebenenfalls kann die Lichtaustrittsfläche zur Erhöhung ihrer optischen Qualität nachfolgend noch anpoliert werden.

Wenn die erfindungsgemäße Anordnung ohne einen Lichtwellenleiter 8 ausgeführt werden soll, wird vor dem Anspritzschritt anstelle des Lichtwellenleiters 8 ein im wesentlichen entsprechend geformtes Abstandsteil verwendet. Das Abstandsteil wird nach dem Anspritzschritt entfernt und läßt in dem Schutzgehäuse einen komplementär geformten Lichtaustrittskanal zurück.

Sofern die genannten Prozeßschritte für mehrere erfindungsgemäße Anordnungen gemeinsam auf einem Leadframe durchgeführt wurden, wird dieser anschließend (oder ggf. auch schon zu einem geeigneten früheren Zeitpunkt) in einem Vereinzelungsschritt in die einzelnen die Träger 1 bildenden Montagefelder aufgetrennt. Die Vereinzelung kann beispielsweise durch einen Stanz-, Läserschneid- oder Ätzschritt erfolgen.

Je nach Bedarfsfall kann die erfindungsgemäße Anordnung unterschiedliche Leistungsmerkmale aufweisen. Typischerweise kann ein 10 W Leistungshalbleiterlaser (optische Nutzleistung) mit Betriebsströmen im Bereich von 20 bis 40 A verwendet werden. Zur Abführung der thermischen Verlustleistung, die in diesem Beispiel etwa 20 bis 40 Watt beträgt, können bis zu 120 Liter Wasser pro Stunde eingesetzt werden. Mit der erfindungsgemäßen Anordnung sind auch höhere optische Nutzleistungen von 20 W und mehr realisierbar.

Die erfindungsgemäße Anordnung kann in vielen technischen Bereichen zur Anwendung kommen, wobei insbesondere an ihren Einsatz als leistungsstarke optische Pumplichtquelle für einen Nd:YAG oder Yt:YAG Laser gedacht ist.

## Patentansprüche

1. Anordnung mit einem lichtemittierenden Leistungshalbieiterbauelement (3), das auf einer metallischen Trägerstruktur (1) unter Ausbildung eines guten Wärmeübergangskontaktes angebracht ist, mit einem Kunststoffschutzkörper (9), der
- durch Anspritzen an die Trägerstruktur (1) angeformt ist und
- das Leistungshalbleiterbauelement (3) unter Aussparung eines Lichtaustrittsbereichs (8) seitlich und deckenseitig im wesentlichen formbündig umhüllt,
und mit einem optisch an das lichtemittierende Leistungshalbleiterbauelement (3) angekoppelten Lichtwellenleiter (8), der das emittierte Licht aus dem Kunststoffschutzkörper (9) herausführt,
**dadurch gekennzeichnet,**
**daß** der Bereich zwischen dem lichtemittierenden Leistungshalbleiterbauelement (3) und dem Lichtwellenleiter (8) zumindest abschnittsweise mit einem transparenten Kunststoff gefüllt ist.

2. Anordnung nach Anspruch 1,
**dadurch gekennzeichnet,**
**daß** im Kunststoffschutzkörper (9) dispergierte Füllstoffpartikel, insbesondere Glaspartikel zur Anpassung der thermomechanischen Eigenschaften des Kunststoffschutzkörpermaterials an die thermische Ausdehnung des Leistungshalbleiterbauelements vorhanden sind.

3. Anordnung nach einem der Ansprüche 1 oder 2,
**dadurch gekennzeichnet,**
**daß** der Kunststoffschutzkörper (9) aus einem im wesentlichen opaken Kunststoffmaterial besteht.

4. Anordnung nach einem der vorhergehenden Ansprüche,
**dadurch gekennzeichnet,**
**daß** der Kunststoffschutzkörper (9) aus einem Thermoplast oder einem Duroplast besteht.

5. Anordnung nach einem der vorhergehenden Ansprüche,
**dadurch gekennzeichnet,**
**daß** die Trägerstruktur (1) ein aus einem panel- oder bandförmigen Metallblech, insbesondere einem Leadframe gefertigtes Vereinzelungsteil, insbesondere Stanzteil ist.

6. Anordnung nach einem der vorhergehenden Ansprüche,
**dadurch gekennzeichnet,**
**daß** die Trägerstruktur (1) mit einem Kühlmedium, insbesondere Wasser in thermischem Kontakt steht und von diesem zumindest teilflächig um- oder angeströmt wird.

7. Anordnung nach Anspruch 6,
**dadurch gekennzeichnet,**
**daß** die Trägerstruktur (1) mit einem Mikrokanäle und/oder Mikrolamellen (6) aufweisenden Wärmeaustauschkörper versehen ist.

8. Anordnung nach Anspruch 7,
**dadurch gekennzeichnet,**
**daß** der Wärmeaustauschkörper in unmittelbarer Nähe des Leistungshalbleiterbauelements (3) an der dem Leistungshalbleiterbauelement (3) abgewandten Seite der Trägerstruktur (1) angebracht ist.

9. Anordnung nach einem der vorhergehenden Ansprüche,
**dadurch gekennzeichnet,**
**daß** der Lichtwellenleiter (8) an seinen beiden Längsseiten mit einer Beschichtung, insbesondere SiO₂-Beschichtung, zur Strahlführung versehen ist.

10. Anordnung nach einem der vorhergehenden Ansprüche,
**dadurch gekennzeichnet,**
**daß** in dem Lichtwellenleiter (8) eine eine Mehrzahl von Einzellichtwellenleitern realisierende Lichtwellenfuhrungsstruktur ausgebildet ist.

11. Anordnung nach Anspruch 10,
**dadurch gekennzeichnet,**
**daß** bezüglich eines Einzellichtwellenleiters die optische Eintritts- und die optische Austrittsquerschnittsfläche unterschiedlich groß sind und/oder daß bezüglich mehrerer Einzellichtwellenleiter die geometrische Anordnung der optischen Eintrittsquerschnittsflächen unterschiedlich zu der geometrischen Anordnung der Austrittsquerschnittsflächen ist.

12. Anordnung nach einem der vorhergehenden Ansprüche,
**dadurch gekennzeichnet,**
**daß** zur optischen Ankopplung des Lichtwellenleiters (8) an das lichtemittierende Leistungshalbleiterbauelement (3) im Strahlengang zwischen dem Leistungshalbleiterbauelement (3) und dem Lichtwellenleiter (8) eine insbesondere reflektive oder diffraktive Optik vorgesehen ist.

13. Anordnung nach Anspruch 12,
**dadurch gekennzeichnet,**
**daß** die Optik durch eine Zylinderlinse (7) realisiert ist.

14. Anordnung nach einen der vorhergehenden Ansprüche,
**dadurch gekennzeichnet,**
**daß** der transparente Kunststoff Silikon ist.

15. Anordnung nach einem der vorhergehenden Ansprüche,
**dadurch gekennzeichnet,**
**daß** es sich bei dem lichtemittierenden Leistungshalbleiterbauelement (3) um einen Halbleiterlaser, insbesondere Halbleiterlaserbarren handelt.

16. Verfahren zur Herstellung einer Anordnung mit lichtemittierendem Leistungshalbleiterbauelement,
bei dem in einem ersten Schritt das lichtemittierende Leistungshalbleiterbauelement (3) unter Ausbildung eines guten Wärmeübergangskontaktes an eine metallische Trägerstruktur (1) angebracht und elektrisch kontaktiert wird, und
in einem zeitlich vor oder nach dem ersten Schritt ausführbaren zweiten Schritt ein Lichtwellenleiter (8) an der Trägerstruktur (1) festgelegt wird,
und in einem dritten Schritt die Trägerstruktur (1) mit lichtemittierendem Leistungshalbleiterbauelement (3) mit einer den Kunststoffschutzkörper (9) bildenden Kunststoffmasse umspritzt wird;
**dadurch gekennzeichnet,**
**daß** der Lichtwellenleiter (8) im dritten Schritt vollständig in den Kunststoffschutzkörper (9) eingehüllt wird, und
**daß** in einem vierten Schritt eine Lichtaustrittsfläche des Lichtwellenleiters (8) im Bereich des Außenumfangs des Kunststoffschutzkörpers (9) freigelegt wird.

17. Verfahren nach Anspruch 16,
**dadurch gekennzeichnet,**
**daß** die Trägerstruktur zumindest in dem ersten Schritt als Montagefeld in einem flächigen Metallblech (Leadframe) realisiert ist, und daß in einem später erfolgenden Vereinzelungsschritt eine Auftrennung des Metallbleches in die einzelnen Anordnungen erfolgt.

18. Verfahren nach Anspruch 16 oder 17,
**dadurch gekennzeichnet,**
**daß** im Rahmen des vierten Schrittes zum Freilegen der Lichtaustrittsfläche des Lichtwellenleiters (8) ein integral am Kunststoffschutzkörper angeformter Kunststoffüberstand (16) abgebrochen wird.

19. Verfahren nach einem der Ansprüche 16 bis 18,
**dadurch gekennzeichnet,**
**daß** nach dem vierten Schritt die freigelegte Lichtaustrittsfläche des Lichtwellenleiters (8) poliert wird.

## Claims

1. Arrangement with a light-emitting power semiconductor component (3), which is mounted on a metallic carrier structure (1), forming a good heat transfer contact, with a protective body of plastic (9), which
- is moulded on the carrier structure (1) by injection-moulding and
- envelopes the power semiconductor component (3) at the sides and on top in such a way that it is substantially flush with it, while leaving a light-exiting region (8),
and with an optical waveguide (8), which is optically coupled to the light-emitting power semiconductor component (3) and leads the emitted light out of the protective body of plastic (9),
**characterized in that** the region between the light-emitting power semiconductor component (3) and the optical waveguide (8) is filled at least in certain portions with a transparent plastic.

2. Arrangement according to Claim 1, **characterized in that** filler particles, in particular glass particles, dispersed in the protective body of plastic (9), are present to adapt the thermomechanical properties of the material of the protective body of plastic to the thermal expansion of the power semiconductor component.

3. Arrangement according to either of Claims 1 and 2,
**characterized in that** the protective body of plastic (9) consists of a substantially opaque plastic material.

4. Arrangement according to one of the preceding claims, **characterized in that** the protective body of plastic (9) consists of a thermoplastic or thermosetting material.

5. Arrangement according to one of the preceding claims, **characterized in that** the carrier structure (1) is a separated part, in particular a punched part, produced from a metal sheet in the form of a panel or strip, in particular a leadframe.

6. Arrangement according to one of the preceding claims, **characterized in that** the carrier structure (1) is in thermal contact with a cooling medium, in particular water, and has this cooling medium flowing against or around at least part of its surface.

7. Arrangement according to Claim 6, **characterized in that** the carrier structure (1) is provided with a heat exchange body having micro-channels and/or micro-lamellae (6).

8. Arrangement according to Claim 7, **characterized in that** the heat exchange body is mounted in the direct vicinity of the power semiconductor component (3), on the side of the carrier structure (1) facing away from the power semiconductor component (3).

9. Arrangement according to one of the preceding claims, **characterized in that** the optical waveguide (8) is provided on both its longitudinal sides with a coating, in particular a SiO₂ coating, for the guidance of rays.

10. Arrangement according to one of the preceding claims, **characterized in that** a lightwave guiding structure, creating a plurality of individual optical waveguides, is formed in the optical waveguide (8).

11. Arrangement according to Claim 10, **characterized in that**, with respect to one individual optical waveguide, the optical entry cross-sectional area and the optical exit cross-sectional area are of different sizes and/or, with respect to a number of individual optical waveguides, the geometrical arrangement of the optical entry cross-sectional areas is different from the geometrical arrangement of the exit cross-sectional areas.

12. Arrangement according to one of the preceding claims, **characterized in that**, for the optical coupling of the optical waveguide (8) to the light-emitting power semiconductor component (3), a particularly reflective or diffractive optical system is provided in the path of rays between the power semiconductor component (3) and the optical waveguide (8).

13. Arrangement according to Claim 12, **characterized in that** the optical system takes the form of a cylindrical lens (7).

14. Arrangement according to one of the preceding claims, **characterized in that** the transparent plastic is silicone.

15. Arrangement according to one of the preceding claims, **characterized in that** the light-emitting power semiconductor component (3) is a semiconductor laser, in particular a semiconductor laser bar.

16. Method of producing an arrangement with a light-emitting power semiconductor component, in which, in a first step, the light-emitting power semiconductor component (3) is mounted on a metallic carrier structure (1), forming a good heat transfer contact, and is electrically contacted, and, in a second step, which can be carried out at a time before or after the first step, an optical waveguide (8) is fixed on the carrier structure (1), and, in a third step, the carrier structure (1) with the light-emitting power semiconductor component (3) is encapsulated in a plastic material forming the protective body of plastic (9), **characterized in that**, in the third step, the optical waveguide (8) is completely enveloped in the protective body of plastic (9), and **in that**, in a fourth step, a light-exiting area of the optical waveguide (8) is exposed in the region of the outer circumference of the protective body of plastic (9) .

17. Method according to Claim 16, **characterized in that**, at least in the first step, the carrier structure is realized as a mounting zone in a flat-form metal sheet (leadframe), and **in that**, in a separating step taking place later, the metal sheet is divided up into the individual arrangements.

18. Method according to Claim 16 or 17, **characterized in that**, as part of the fourth step, for exposing the light-exiting area of the optical waveguide (8), an overhang of plastic (16) integrally moulded on the protective body of plastic is broken off.

19. Method according to one of Claims 16 to 18, **characterized in that**, after the fourth step, the exposed light-exiting area of the optical waveguide (8) is polished.

## Revendications

1. Arrangement comportant un composant semi-conducteur de puissance émettant de la lumière (3) qui est monté sur une structure porteuse métallique (1) en réalisant un bon contact de transmission de la chaleur, un corps de protection en matière plastique
- qui est réalisé par moulage par injection sur la structure porteuse (1), et
- qui entoure le composant semi-conducteur de puissance (3) latéralement et du côté du capot, sensiblement conformément au moule, en ménageant une zone de sortie de lumière (8),
et une fibre optique (8) qui est couplée au composant semi-conducteur de puissance émettant de la lumière (3) et qui guide la lumière émise hors du corps de protection en matière plastique (9),
**caractérisé en ce que** la région entre le composant semi-conducteur de puissance émettant de la lumière (3) et la fibre optique (8) est remplie au moins par portions d'une matière plastique transparente.

2. Arrangement selon la revendication 1, **caractérisé en ce qu'**il existe des particules de charge dispersées dans le corps de protection en matière plastique (9), en particulier des particules de verre, en vue d'adapter les propriétés thermomécaniques de la matière plastique du corps de protection à la dilatation thermique du composant semi-conducteur de puissance.

3. Arrangement selon l'une des revendications 1 ou 2, **caractérisé en ce que** le corps de protection en matière plastique (9) est constitué par une matière plastique sensiblement opaque.

4. Arrangement selon l'une des revendications précédentes, **caractérisé en ce que** le corps de protection en matière plastique (9) est constitué par une matière thermoplastique ou une résine thermodurcissable.

5. Arrangement selon l'une des revendications précédentes, **caractérisé en ce que** la structure porteuse (1) est une pièce de séparation, en particulier une pièce estampée, fabriquée à partir d'un tôle métallique en forme de panneau ou de bande, en particulier une grille de connexion.

6. Arrangement selon l'une des revendications précédentes, **caractérisé en ce que** la structure porteuse (1) est en contact thermique avec un fluide de refroidissement, en particulier de l'eau, qui arrive au moins sur la partie de la surface de la structure porteuse ou bien circule autour de celle-ci.

7. Arrangement selon la revendication 6, **caractérisé en ce que** la structure porteuse (1) est dotée d'un corps échangeur de chaleur comportant des micro-canaux et/ou des micro-lamelles (6).

8. Arrangement selon la revendication 7, **caractérisé en ce que** le corps échangeur de chaleur est monté à proximité immédiate du composant semi-conducteur de puissance (3) du côté de la structure porteuse (1) qui est opposé au composant semi-conducteur de puissance (3).

9. Arrangement selon l'une des revendications précédentes, **caractérisé en ce que** la fibre optique (8) est dotée sur ses deux faces longitudinales d'un couche, en particulier d'une couche de SiO₂, en vue de guider les rayons.

10. Arrangement selon l'une des revendications précédentes, **caractérisé en ce qu'**une structure de guidage d'ondes lumineuse réalisant une pluralité de fibres optiques individuelles est conformée dans la fibre optique (8).

11. Arrangement selon la revendication 10, **caractérisé en ce que** la surface d'entrée optique en coupe transversale et la surface de sortie optique en coupe transversale ont une dimension différente de celle d'une fibre optique individuelle et/ou, dans le cas de plusieurs fibres optiques individuelles, l'arrangement géométrique des surfaces d'entrée optiques en coupe transversale est différent de l'arrangement géométrique des surfaces de sortie optiques en coupe transversale.

12. Arrangement selon l'une des revendications précédentes, **caractérisé en ce qu'**il est prévu une optique en particulier de réflexion ou de diffraction dans le chemin de faisceau entre le composant semi-conducteur de puissance (3) et la fibre optique (8) en vue d'accoupler optiquement la fibre optique (8) au composant semi-conducteur de puissance émettant de la lumière (3).

13. Arrangement selon la revendication 12, **caractérisé en ce que** l'optique est réalisée par une lentille cylindrique (7).

14. Arrangement selon l'une des revendications précédentes, **caractérisé en ce que** la matière plastique transparente est du silicone.

15. Arrangement selon l'une des revendications précédentes, **caractérisé en ce que** le composant semi-conducteur de puissance émettant de la lumière (3) est un laser à semi-conducteur, en particulier un barreau de laser à semi-conducteur.

16. Procédé de fabrication d'un arrangement à composant semi-conducteur de puissance émettant de la lumière (3), dans lequel dans une première étape le composant semi-conducteur de puissance émettant de la lumière (3) est monté sur une structure porteuse métallique (1) en réalisant un bon contact de transmission de la chaleur et est mis en contact électrique, et
dans une deuxième étape précédent ou suivant la première étape une fibre optique (8) est fixée à la structure porteuse (1),
et dans une troisième étape la structure porteuse (1) comportant le composant semi-conducteur de puissance émettant de la lumière (3) est enrobée d'une composition de matière plastique formant le corps de protection en matière plastique (9),
**caractérisé en ce que** la fibre optique (8) dans la troisième étape est totalement entourée par le corps de protection en matière plastique (9), et **en ce que** dans une quatrième étape une face de sortie de lumière de la fibre optique (8) est mise à découvert à la périphérie du corps de protection en matière plastique (9).

17. Procédé selon la revendication 16, **caractérisé en ce que** la structure porteuse est réalisée au moins dans la première étape sous forme de zone de montage dans une tôle métallique plane (grille de connexion), et **en ce que** dans une étape de séparation ultérieure la tôle métallique est divisée en arrangements individuels.

18. Procédé selon la revendication 16 ou 17, **caractérisé en ce que** dans le cadre de la quatrième étape une saillie de matière plastique (16) formée en venue de matière sur le corps de protection en matière plastique est cassée en vue de mettre à découvert la face de sortie de lumière de la fibre optique (8).

19. Procédé selon l'une des revendications 16 à 18, **caractérisé en ce que** après la quatrième étape la face de sortie de lumière, qui a été mise à découvert sur la fibre optique, est polie.
